Europäisches Patentamt

European Patent Office

Office européen des brevets

(11) Publication number: **0 160 440**
**A1**

(12) # EUROPEAN PATENT APPLICATION

(21) Application number: **85302557.5**

(22) Date of filing: **11.04.85**

(51) Int. Cl.⁴: **G 01 R 31/08**

(30) Priority: **11.04.84 US 599048**

(43) Date of publication of application:
**06.11.85 Bulletin 85/45**

(84) Designated Contracting States:
**AT BE CH DE FR GB IT LI NL SE**

(71) Applicant: **RAYCHEM CORPORATION**
**300 Constitution Drive**
**Menlo Park California 94025(US)**

(72) Inventor: **Mascia, Michael**
**258 Grant Street**
**Redwood City California 94062(US)**

(72) Inventor: **Reed, James Patrick**
**1745 Beach Street Apt No. 10**
**San Fransisco California 94123(US)**

(74) Representative: **Benson, John Everett et al,**
**Raychem Limited Intellectual Property Law Department**
**Swan House 37-39, High Holborn**
**London WC1(GB)**

(54) Apparatus for detecting and obtaining imformation about changes in variables.

(57) Method and apparatus for detecting and obtaining information about (particularly locating) an event, i.e. a change in a variable. In a preferred embodiment, three conductors follow an elongate path. Two of them (called the locating member (11) and the source member (12) are connected to each other at each end of the path and to a power source (15) thus forming a reference circuit in which a current of known size flows. The locating member (11) has known impedance characteristics along its length, the third conductor called the return member (16) is connected to one end of the locating member through a voltage-measuring device (14), but is otherwise insulated from the locating member (11) and the source member (12). When the event occurs, a connection (E) of known resistance is made between the locating member (11) and the return member (12). The voltage-measuring device (14) is then used to measure the voltage drop between the connection point and one end of the locating member (11), and the location of the event can then be calculated.

FIG__1

DESCRIPTION

APPARATUS FOR DETECTING AND OBTAINING
INFORMATION ABOUT CHANGES IN VARIABLES

This invention relates to methods and apparatus for detecting and obtaining information about (particularly locating) changes in variables.

## Introduction to the Invention

A number of methods have been proposed to detect changes in variables along an elongate path, e.g. the occurrence of a leak (of water or another liquid or gas), insufficient or excessive pressure, too high or too low a temperature, the presence or absence of light or another form of electromagnetic radiation, or a change in the physical position of a movable member, e.g. a valve in a chemical process plant or a window in a building fitted with a burglar alarm system. Changes of this kind are referred to in this specification by the generic term "event". The known methods suffer from serious disadvantages. For example, they make use of time domain reflectometer techniques (and are, therefore, expensive), and/or give unreliable results when used over usefully long elongate paths, and/or make use of electrical conductors whose primary purpose is to carry a current (e.g. a telecommunication signal) under normal operating conditions. Reference may be made for example to U.S. Patents Nos. 1,084,910, 2,581,213, 3,248,646, 3,384,493, 3,800,216, and 3,991,413, U.K. Patent No. 1,481,850 and German Offenlegungschriften Nos. 3,001,150.0 and 3,225,742.

The application corresponding to United States Application Serial No. 509,897 describes an improved method and apparatus for monitoring for the occurrence of an event, and for detecting and obtaining information about the event upon its occurrence (i.e as soon as it occurs or at some time after it has occurred). In that method, upon occurrence of the event, at least one electrical connection is made between a source member and a locating member of known impedance characteristics, the connection(s) being effective at a first point at which the event takes place (or whose location is defined by some other characteristic of the event). A current of known size is then driven through the electrical connection(s) and down the locating member to a second point whose location is known. The voltage drop between the first and second points is then measured and the location of the first point can then be determined.

## SUMMARY OF THE INVENTION

The present invention provides a system which is somewhat similar to that just described, but differs from it in that (a) the source member is connected to the locating member, so that current passes through the locating member in the absence of an event, and, (b) upon occurrence of the event, electrical connection is made between the locating member and the return member.

Accordingly, in one embodiment, the present invention provides an apparatus for monitoring for the occurrence of an event, and for detecting and obtaining information about the event when it occurs, which apparatus comprises

(1)    an elongate electrically conductive locating member whose impedance from one end to any point on the locating member defines the spatial relationship between that end and that point;

(2)    an elongate electrically conductive return member;

(3)    an event-sensitive connection means which, upon
       occurrence of an event, permits or effects electrical connection between the locating member and the
       return member, the connection being effective at a
       first point on the locating member which is defined
       by at least one characteristic of the event;

(4)    electrically conductive source member;

(5)    a voltage-measuring device which is electrically
       connected to a second point on the locating member
       and to the return member, and which, in the
       absence of an event, is not otherwise connected to
       the locating member, so that, when occurrence of an
       event causes an electrical connection to be made
       between the locating and return members, this
       results in the formation of a test circuit·which
       comprises (a) the connection, (b) that part of the
       locating member which lies between the first and
       second points, (c) the voltage-measuring device,
       and (d) part of the return member, the voltage-
       measuring device having an impedance which is very
       high by comparison with any unknown part of the
       other components of the reference circuit; and

(6)    a power source which is electrically connected to
       the second point on the locating member and which,
       when an event takes place, forms part of a
       reference circuit which comprises

       (a)   at least part of the source member,

(b)   that part of the locating member which lies
      between the first and second points, and

(c)   the power source,

and in which reference circuit a current of known size
is transmitted between the first and second points on
the locating member.

In another embodiment, the present invention provides a
method for monitoring for the occurence of an event, and for
detecting and obtaining information about the event upon its
occurrence, which method comprises operating an apparatus of
the invention on a continuous or periodic schedule in order
to determine when an event takes place.

## BRIEF DESCRIPTION OF THE DRAWING

The invention is illustrated in the accompanying drawing,
in which

Figure 1 is a generalized schematic circuit diagram
      of the method of the present invention,

Figures 2-19 are schematic circuit diagrams of the
      method and apparatus of the invention, and

Figures 20-22 are graphs showing how the voltage drop
      between the first and second points on the locating
      member can vary in different systems of the
      invention.

### DETAILED DESCRIPTION OF THE INVENTION

As discussed in the Application corresponding to U.S. Serial No. 509,897, the connection to the locating member is said to be "effective at the first point" in order to include those situations in which a plurality of such connections is made when the event takes place, the first point then being the electrical center of those connections.

### 1.  THE ELECTRICAL CHARACTERISTICS OF THE INVENTION

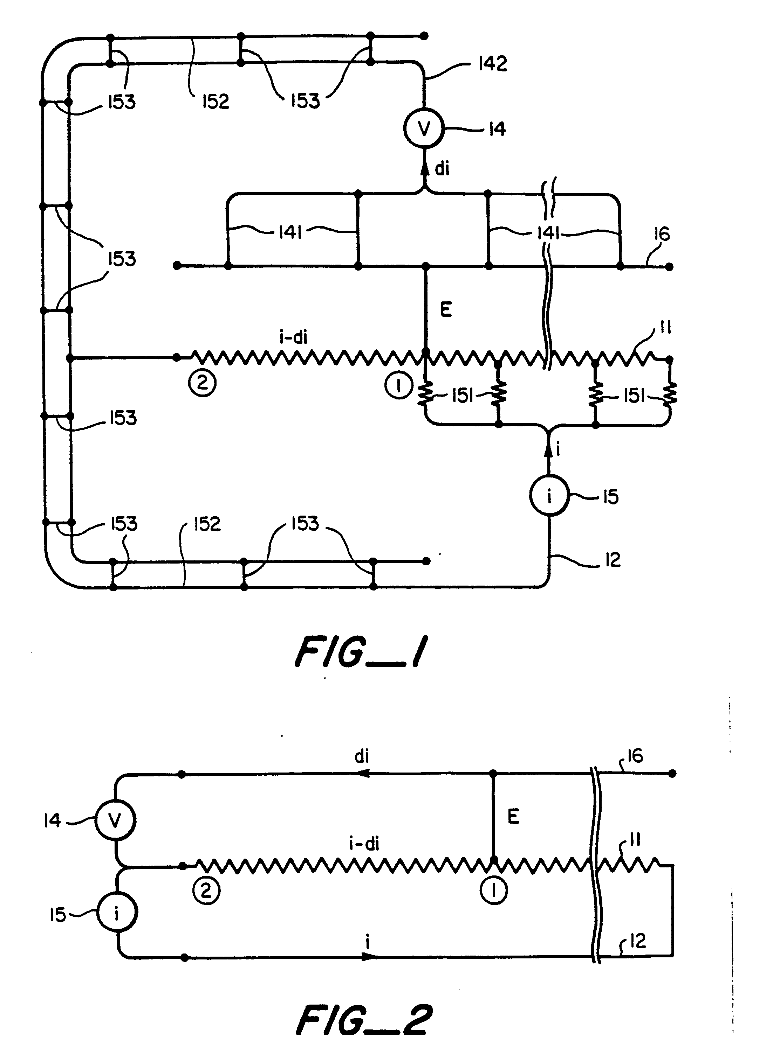

The basic electrical characteristics of the invention can best be understood by reference to Figure 1, which shows an elongate locating member 11, an elongate source member 12, a voltage-measuring device 14, a power source 15 and an elongate return member 16.  Between the source and return members (but not shown in Figure 1) is an event-sensitive connection means (this term being used to include a continuous event-sensitive connection means and a plurality of spaced-apart event-sensitive connection means) which becomes conductive at any location at which an event takes place. In Figure 1, an event has taken place at a first point 1, and an electrical connection E of known resistance has been made between the locating and return members.  The voltage-measuring device 14 is connected via connection means 142 to the locating member at one end thereof, designated by the numeral 2, which is the "second point" in the definition given above.  The voltage-measuring device is also connected to the return member at one or more points (as schematically indicated by the plurality of connections 141) through connections whose impedance is known or very small by comparison with the impedance of the voltage-measuring device. Thus the making of the connection results in the formation of a test circuit which includes the connection, the

0160440

-6-                                MPO869

locating member between points 1 and 2, the voltage-
measuring device and part of the return member.

The power source is connected to point 2 and to the
locating member at one or more points whose distance from
the second point is at least as far as the first point 1, as
schematically indicated by the plurality of connections 151.
Thus the power source forms part of a reference circuit
which comprises the power source, at least that part of the
locating member between points 1 and 2, and the return
member.

The power source 15 and the voltage-measuring device 14
can be connected to the point 2 on the locating member 11 in
any convenient way. Thus, as indicated by the plurality of
conections 153, the connection member 152 and the return
member 16 can be connected to each other at any one or more
locations.

It will be seen that the location of point 1 can be
calculated if the following are known:-

(a)  the current flowing between points 1 and 2,

(b)  the impedance of the components of the test
     circuit,

(c)  the voltage drop measured by the voltage-measuring
     device,

(d)  the location of point 2, and

(e)  the impedance of the locating member between point
     2 and each point on the locating member.

The accuracy of location is limited by the ratio of the impedance of the voltage-measuring device to any unknown part of the impedance of the other components of the test circuit. Accordingly, this ratio should preferably be at least 100, particularly at least 1,000, especially at least 10,000.

Preferably the connection between the locating and return members is an electronic fault having little or no impedance, but if the power source is of sufficient voltage, the system can operate satisfactorily if the connection has substantial impedance, e.g. is an ionic connection, provided that the impedance is known directly or indirectly (e.g. from measurement of the current flowing in the test circuit).

2.  INFORMATION WHICH CAN BE PROVIDED ABOUT AN EVENT

This invention is preferably used to provide the location of an event. However it can be used to provide other information, in the same way as the system described in the application corresponding to U.S. Serial No. 509,897.

3.  EVENTS WHICH CAN BE DETECTED, AND EVENT-SENSITIVE CONNECTION MEANS FOR DETECTING THEM

The invention can be used to provide information about a wide variety of events, through use of appropriate event-detection systems, which are preferably reversible. In many such systems, the locating and return members are physically contacted by a connecting member which insulates the locating and return members prior to occurrence of an event and which, when an event takes place, undergoes a change of shape or a change of state which effects or permits electrical connection between the locating and return members.

Examples of events which can be detected include, but are not limited to, the following.

(A)  The existence of a temperature which is below a first temperature $T_1$ or above a second temperature $T_2$. The connecting member can for example comprise a heat-recoverable polymer, a heat-recoverable memory metal or a bimetallic strip.

(B)  A change in the concentration of a particular substance, which may for example be a gas, a liquid, or a solid dispersed in a gas or liquid. The change can for example cause at least part of the connecting member to change shape, or can change the state of an ionization chamber, or the transmissivity in a photo electric cell, which in turn will cause a switch to connect the locating and return members.

(C)  A change from a first force or pressure $P_1$, to a second force or pressure, $P_2$. For example, the connecting member can be deformable, e.g. composed of air or other fluid insulating material.

(D)  A change in the intensity or other characteristic of electromagnetic radiation or field. Suitable apparatus could for example include a photoelectric cell.

(E)  A change in the position of a valve, e.g. in a refinery or other chemical process plant, thus changing the position of a switch in a connecting member between the locating and return members.

For further details of suitable event-sensitive connection means, reference should be made to the application corresponding to U.S. Serial No. 509,897.

(4) THE LOCATING, SOURCE AND RETURN MEMBERS

The locating member is preferably an elongate member, this term being used to denote a member having a length which is substantially greater, e.g. at least 100 times greater, often at least 1,000 times greater, sometimes at least 10,000 times greater or even at least 100,000 times greater, than either of its other dimensions. However, the locating member can also be in the form of a sheet or some other more complex shape. Under some circumstances, considerable advantages may result from the use of a locating member which comprises a plurality of spaced-apart impedances which are connected by intermediate elongate components of low impedance. For further details, reference should be made to the application corresponding to U.S. Serial No. 618,106.

The return member preferably has the same general configuration and follows the same general path as the locating member.

In many cases, the source member is also elongate and follows the same general path as the locating member. However, this is not necessary when the locating and return members follow a path in the form of a loop.

In many cases, it is convenient for one, two or all three of the locating, return and source members to comprise simple conductors which have resistance but no reactance. The locating, return and source members can be the same or different.  Preferably they are physically combined as a single flexible cable, e.g. by wrapping all three around another elongate member or by wrapping the return and locating members around the source member.  In order to reduce the input voltage required to provide a controlled current in the reference circuit, the source member can be less resistive than the locating member.  On the other hand, it is convenient, for making splices between cables at intermediate points, if the locating and return members are identical.  In order to ensure that the resistance of the return member is not significant in the test circuit, the return member can be less resistive than the locating member.  In addition, the source or return member can be relatively large and strong (and, therefore, usually of low resistance, for example, less than 0.01 times the resistance of the locating member) in order that the apparatus has good physical properties.  For disclosure of preferred ways of assembling the locating, return and source members, reference may be made to the Application corresponding to U.S. Serial Nos. 556,740 and 556, 829.

The locating member preferably has a resistance of at least 0.1 ohm/ft, particularly at least 1 ohm/ft, e.g. 1 to 5 ohm/foot.  On the other hand, its resistance should preferably not be too high and is preferably less than $10^4$ ohm/foot, particularly less than $10^2$ ohm/foot, especially less than 20 ohm/foot.  The locating member is preferably of constant cross-section along its length.  In addition, it is preferred that the locating member should have a temperature coefficient of impedance (usually resistance) which averages less than 0.003, particularly less than 0.0003, especially less than 0.00003, per degree Centigrade over at least one 25° temperature range between -100°C and +500°C, and preferably over the temperature range 0° to 100°C, especially over the temperature range 0° to 200°C.

For further details of suitable locating, source and return members, reference should be made to the application corresponding to U.S. Serial No. 509,897.

(5) THE POWER SUPPLY

The current which is transmitted between the first and second points must be of known size, and is preferably supplied by a controlled current source. The current may be a direct current or an alternating current of regular sinusoidal or other form. The current which flows between the first and second points is preferably in the range of 0.05 to 100 milliamps, particularly 0.1 to 10 milliamps, e.g. 0.5 to 3 milliamps. For further details of suitable power supplies reference should be made to the application correcponding to U.S. Serial No. 509,897.

(6) THE VOLTAGE-MEASURING DEVICE

The voltage-measuring device can be of any kind, and suitable devices are well known to those skilled in the art. Preferably the voltage-measuring device is a voltmeter which has a resistance of at least 10,000 ohms, preferably at least 1 megohm, especially at least 10 megohms.

(7) PHYSICAL AND ELECTRICAL RELATIONSHIPS BETWEEN THE
    COMPONENTS OF THE APPARATUS

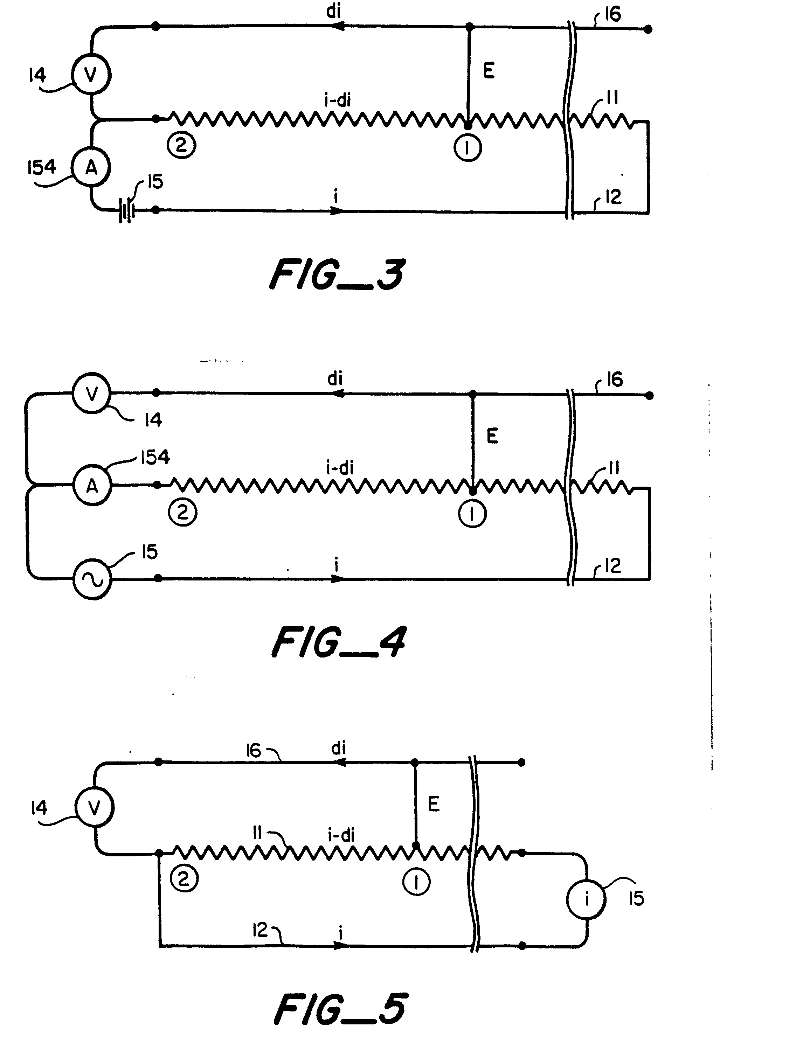

As briefly indicated in the description of Figure 1, the physical and electrical relationships between the components of the apparatus of the invention can be widely varied. Figures 2-19 show a number of different arrangements which are specific examples of the circuit generically illustrated in Figure 1 and of various preferred embodiments of the invention. In each of Figures 2-19, there is a power source 15 (a controlled current source except in Figures 3 and 4), a voltage-measuring device 14, a locating member 11, a source member 12, and a return member 16. A number of the Figures show a connection E, $E_1$ or $E_2$ which results from occurrence of an event, and a number of other Figures show switches S, $S_1$ or $S_2$.

Some of the different possible relationships between the components will now be enumerated, using Figures 2-19 as examples of these relationships.

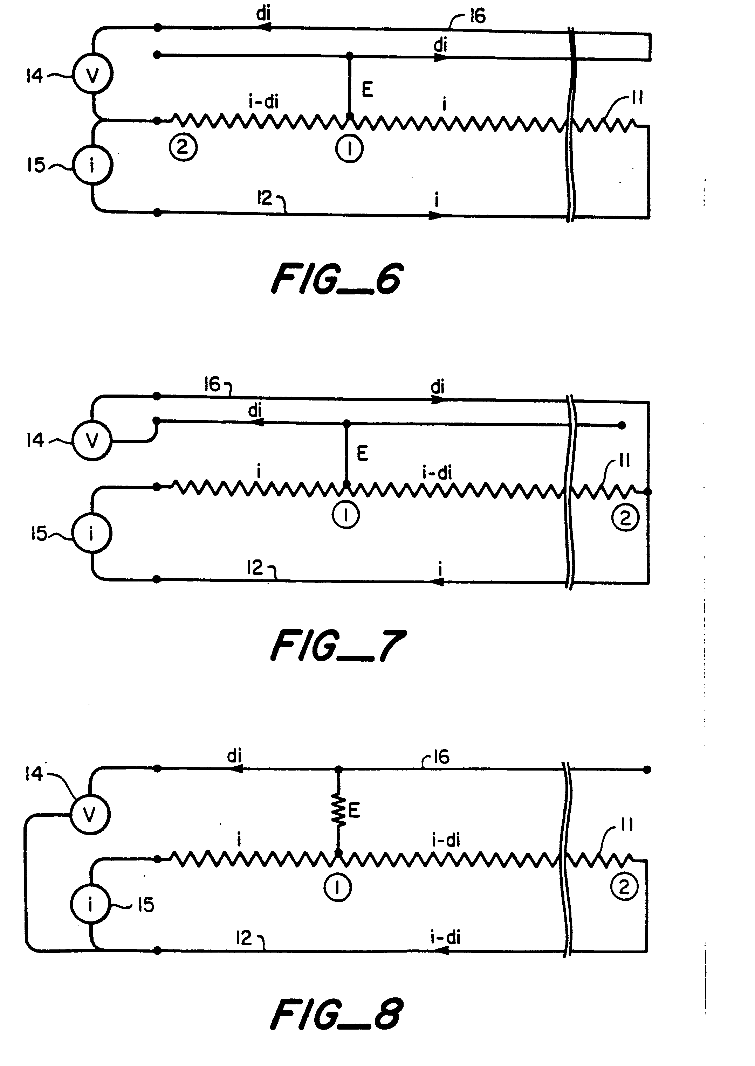

(A) The voltage-measuring device can be positioned near the second point on the locating member (Figures 2-6 and 10-19) or near the opposite end of (Figures 7 and 8). In most cases, the power source and the voltage-measuring device are positioned near to each other (Figures 2-4 and 6-19).

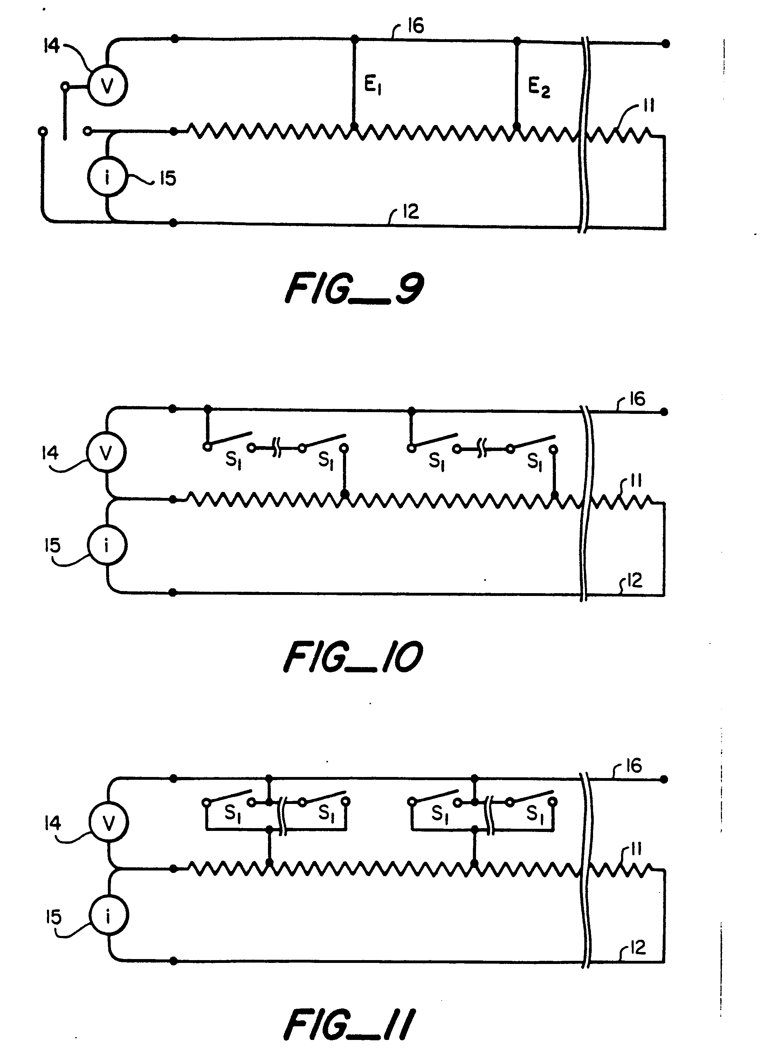

(B) The apparatus can include one or more switches (e.g. as in Figure 9), to provide a first arrangement in which the second point is at one end of the locating member, and a second arrangement in which the second point is at the opposite end, thus making it possible to measure the first point from one end or the other end.

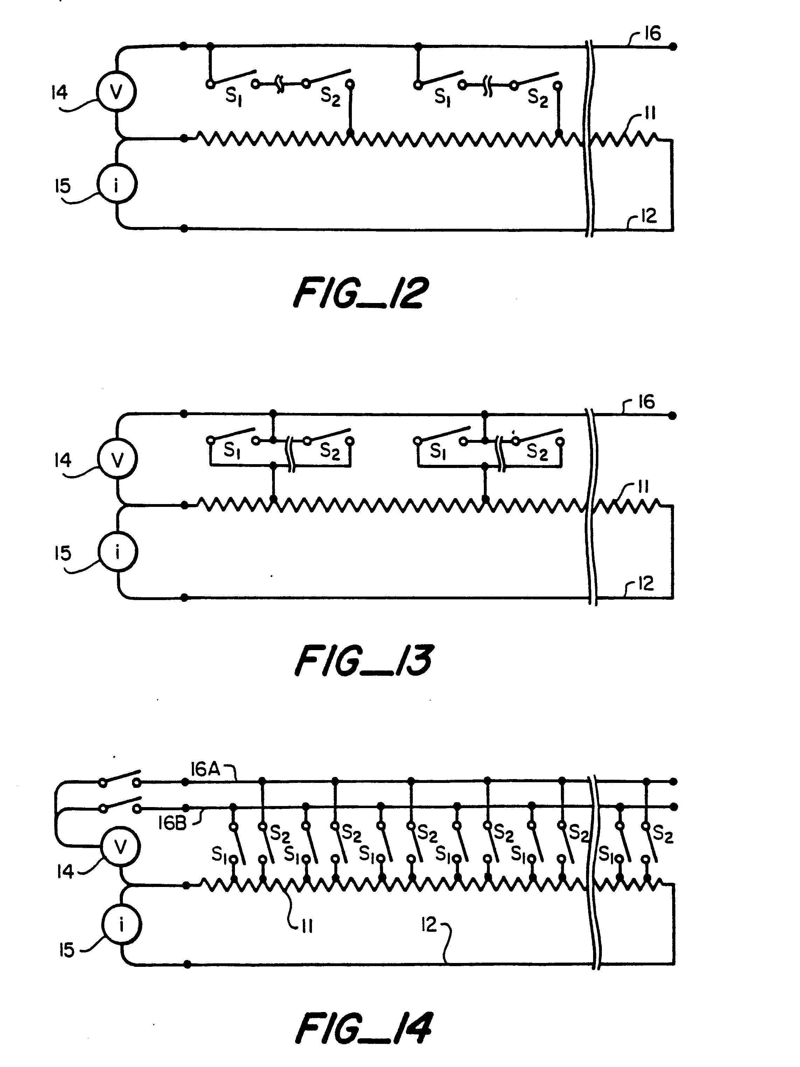

(C) The event can comprise the existence of a particular condition at each of a plurality of spaced-apart locations (Figure 10) or at at least one of a plurality of spaced-apart locations (Figure 11), and the connection member comprises a plurality of condition-sensitive members which are electrically connected in series (Figure 10) or in parallel (Figure 11).

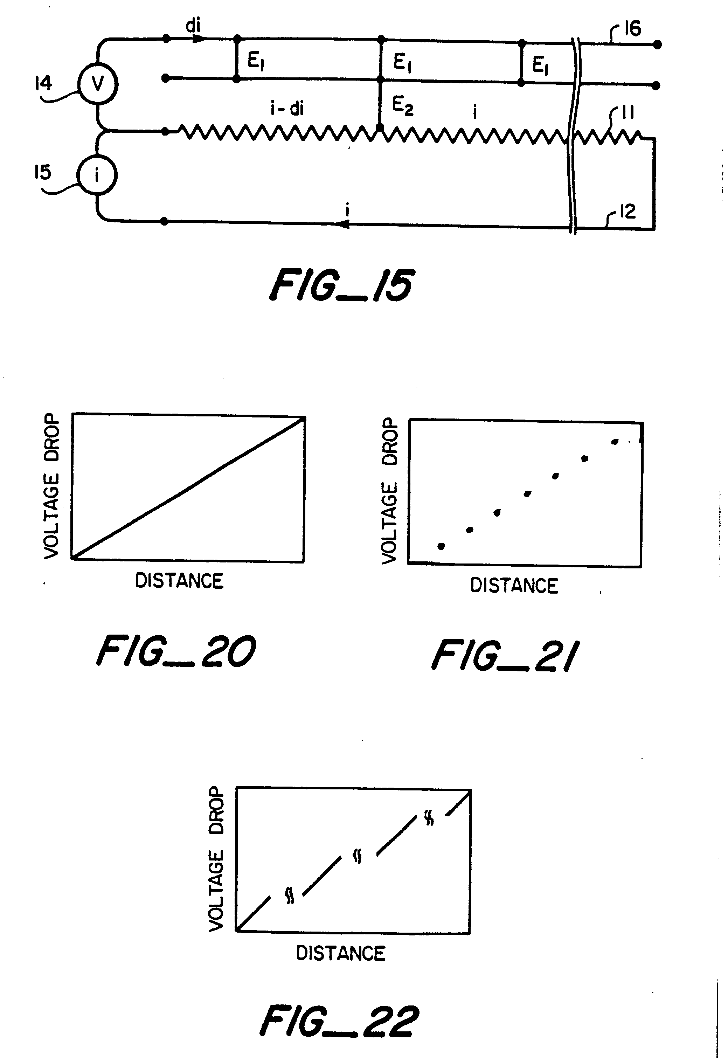

(D) The event comprises a first condition at a first location
    and/or a second condition at a second location (which
    may be immediately adjacent the first location), and the
    event-sensitive member comprises (a) a first-condition-
    sensitive member at the first location and (b) a second-
    condition-sensitive member which is at the second
    location, and which is electrically connected in series
    with the first-condition-sensitive member (e.g. as in
    Figure 12) or in parallel with the first-condition-
    sensitive member (e.g. as in Figure 13).

(E) It is also possible (e.g. as in Figure 14) for the
    system to include two or more return members, which
    become respectively connected to the locating member
    when a particular condition (different for each return
    member) exists.  The system can also include switches
    such that it is possible to disconnect all but one of the
    return members and thus to determine which of the particular conditions exists.

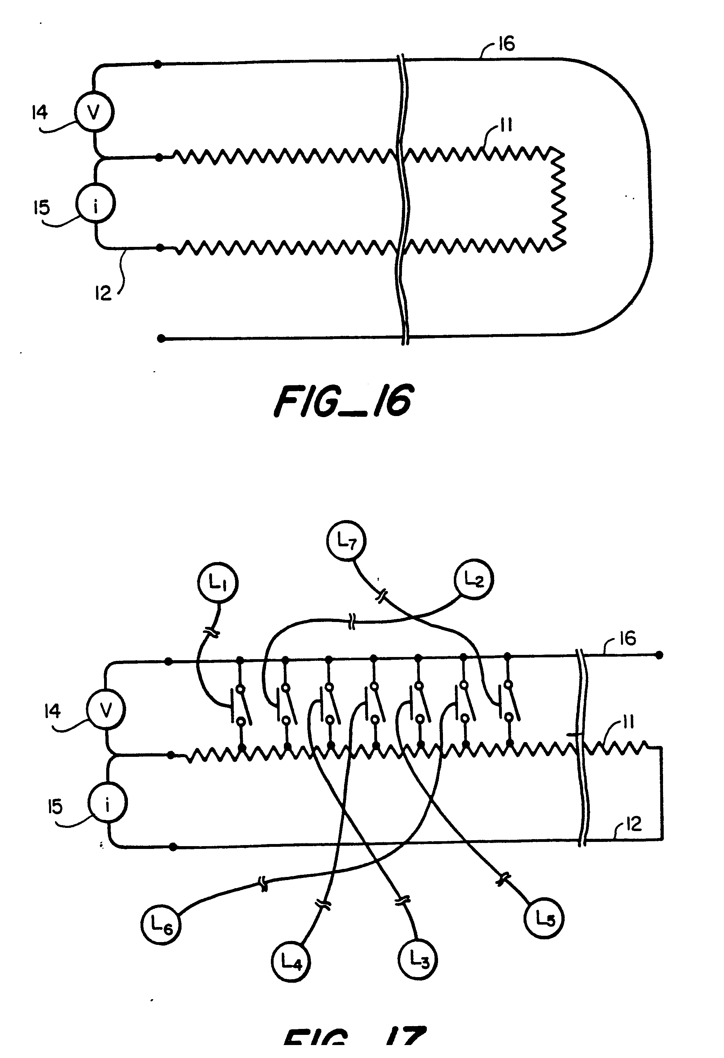

(F) It is also possible (e.g. as in Figure 15) for the
    system to include at least one auxiliary return member
    which is connected to the voltage-measuring device and
    which becomes connected to the return member (or to
    another auxiliary return member) when a particular
    second condition exists, the second condition being different from the first condition which causes the return
    member to become connected to the locating member.

(G) It is also possible (e.g. as in Figure 16) for the
    apparatus to follow an elongate path in the form of a
    loop, so that the source member need not follow the
    elongate path but can simply join, via the power source,
    the two ends of the locating member.

(H) It is also possible (e.g. as in Figure 17) for a plurality of event-detecting stations (which can detect the same or different events) to be positioned at locations which are remote from the locating member and to be electrically (or otherwise) connected to switches (.e.g electromagnetically operated relays) between the locating and return members.

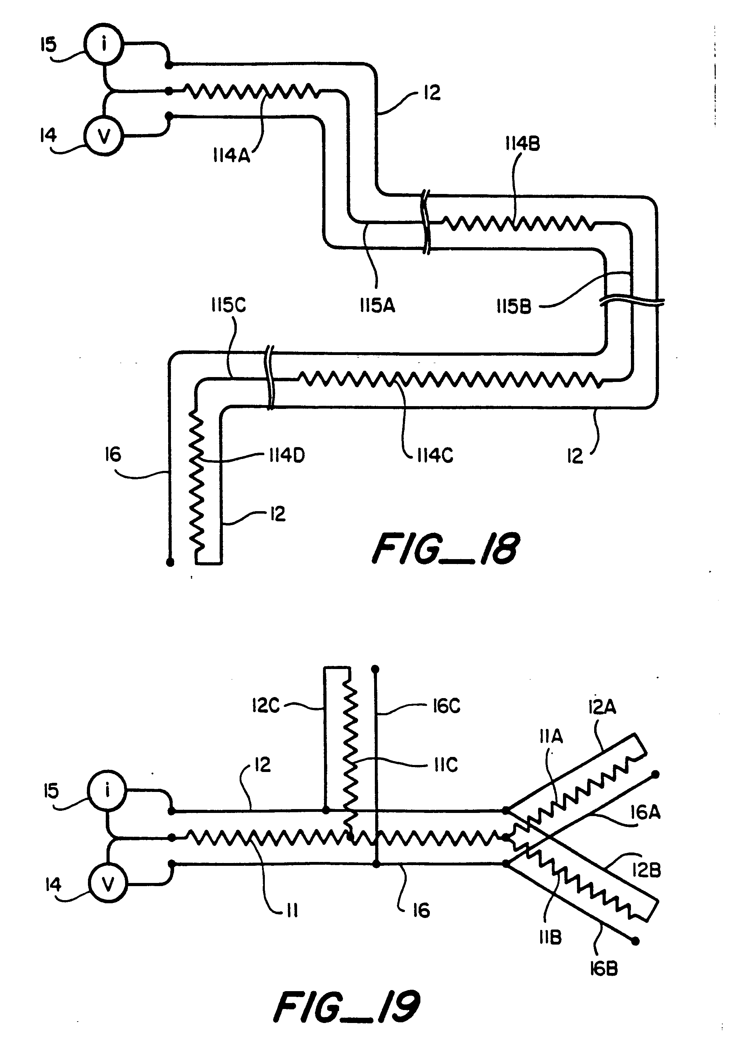

(I) It is also possible (e.g. as in Figure 18), when event-detection is required only in spaced-apart zones, for the locating member to comprise (a) a plurality of elongate spaced-apart locating components (114A, 114B, 114C and 114D in Figure 18), each of which provides a series of points to which the connection can be made and preferably has a relatively high resistance per unit length, and (b) a plurality of elongate spaced-apart intermediate components (115A, 115B, and 115C in Figure 18) which physically separate and electrically connect the locating components, which cannot become directly connected to the return member and which preferably have a relatively low resistance.

(J) The method can also be used to locate events along a branched path, as illustrated in Figure 19. However, when using such a branched system, if the voltage-measuring device shows an event at a distance beyond the first branching point, then there are often two or more possible locations for the fault. If desired, the location can be precisely identified by conencting the controlled current source and voltmeter to the conductors at the branch point(s) (preferably via low resistance drop leads installed at the same time as the detection system). ( This expedient can also be used in unbranched systems in order to provide improved accuracy of location of the event, after the general vicinity of the event has been indicated.) Alternatively, AC current sources of different frequencies can be employed sequentially and filters can be placed in the different branches so that only one branch is being tested at any one time.

## (8) VOLTAGE DROP VS. DISTANCE

The relationship between the voltage drop measured by the voltage-measuring device and the distance between the first and second points will depend on the way in which the apparatus is designed. When connection can be made to the return member at any point along its length, and the locating member is of uniform impedance along its length, then the relationship will be a straight line of uniform slope, as illustrated in Figure 20. When the event-sensitive connection means is discontinuous, so that connection to the locating member is possible only at spaced-apart points, then the relationship will be a series of points as shown in Figure 21. When the locating member is divided into locating and connection zones and can be contacted at any point within a locating zone, as shown in Figure 18, then the relationship is as shown in Figure 22.

## (9)  MEASURING THE VOLTAGE DROP DOWN THE LOCATING MEMBER WITH THE AID OF A REFERENCE IMPEDANCE

When a "fixed" current source is used to provide a very low current, the current may vary substantially (e.g. by about 4%) from the "fixed" value (even when the output voltage is less than the compliance voltage). Other factors may also cause the current in the test circuit to vary with time. Under these circumstances, preferably the test circuit includes a reference impedance which is connected in
series with the locating member, and the location of the
first point is calculated from the ratio of the voltage drop
between the first and second points to the voltage drop over
the reference impedance.  In effect, this procedure measures
the current in the test circuit by measuring the voltage
drop over the reference impedance.  For further details,
reference should be made to the United States Patent
Application Serial No. 603,484, filed by Bonomi and Frank on
April 24, 1984 (MPO932-US1).

CLAIMS

1.      Apparatus for monitoring for the occurrence of an event, and for detecting and obtaining information about the event when it occurs, which apparatus comprises

   (A)  an elongate electrically conductive locating member whose impedance from one end to any point on the locating member defines the spatial relationship between that end and that point;

   (B)  an elongate electrically conductive return member;

   (C)  an event-sensitive connection means which, upon occurrence of an event, permits or effects electrical connection between the locating member and the return member, the connection being effective at a first point on the locating member which is defined by at least one characteristic of the event;

   (D)  electrically conductive source member;

   (E)  a voltage-measuring device which is electrically connected to a second point on the locating member and to the return member, and which, in the absence of an event, is not otherwise connected to the locating member, so that, when occurrence of an event causes an electrical connection to be made between the locating and return members, this results in the formation of a test circuit which comprises (a) the connection, (b) that part of the locating member which lies between the first and second points, (c) the voltage-measuring device, and (d) part of the return member; the voltage-measuring device having an impedance which is very high by comparison with any unknown part of the other components of the reference circuit; and

(F)  a power source which is electrically connected to the second point on the locating member and which, when an event takes place, forms part of a reference circuit which comprises

   (a)  at least part of the source member,

   (b)  that part of the locating member which lies between the first and second points, and

   (c)  the power source,

and in which reference circuit a current of known size is transmitted between the first and second points on the locating member.

2.     Apparatus according to claim 1 wherein the second point on the locating member is at one end thereof, the source member is elongate and the ends thereof are connected to the ends of the locating member, and the return, locating and source members follow substantially the same elongate path.

3.     Apparatus according to claim 1 or 2 wherein the connection is an electronic connection having substantially no impedance.

4.      Apparatus according to claim 1, 2 or 3 wherein the
locating member has a resistance of at least 0.1 ohm/foot,
preferably at least 1 ohm/foot, particularly 1 to 5
ohm/foot, and has a temperature coefficient of impedance
which averages less than 0.003, preferably less than 0.003,
over the temperature range 0 to 100°C.

5.      Apparatus according to any one of the preceding
claims wherein the power source is a controlled current
source which supplies a known fixed current in the range
0.05 to 10 milliamps.

6.      Apparatus according to any one of the preceding
claims wherein the locating and return members are physically contacted by a connecting member which insulates the
locating and return members from each other prior to
occurrence of an event and which, when an event occurs,
undergoes a change of shape or a change of state which
effects or permits electrical connection between the
locating and return members.

7.      A method for monitoring for the occurrence of an
event, and for detecting and obtaining information about the
event upon its occurrence, which method comprises monitoring,
on a continuous or periodic schedule, the voltage measured
by the voltage-measuring device in an apparatus as claimed
in any one of the preceding claims.

FIG_1

FIG_2

0160440

FIG_3

FIG_4

FIG_5

0160440

*FIG_6*

*FIG_7*

*FIG_8*

FIG_9

FIG_10

FIG_11

*FIG_12*

*FIG_13*

*FIG_14*

0160440

FIG_15

FIG_20

FIG_21

FIG_22

0160440

FIG_16

FIG_17

0160440

**FIG_18**

**FIG_19**

| | DOCUMENTS CONSIDERED TO BE RELEVANT | | EP 85302557.5 |

| Category | Citation of document with indication, where appropriate, of relevant passages | Relevant to claim | CLASSIFICATION OF THE APPLICATION (Int. Cl. 4) |
|---|---|---|---|
| X | DE - B2 - 2 455 007 (SEBA-DYNATRO-NIC) | 1-3 | G 01 R 31/08 |
| A | Claim 1 * | 4-7 | |
| | -- | | |
| A | GB - A - 1 352 124 (ELECTRICITY COUNCIL) | 1-3 | |
| | * Fig. 1,2 * | | |
| | -- | | |
| X,D | US - A - 1 084 910 (STEPHENSON) | 1,2 | |
| | * Fig. 1 * | | |
| | -- | | |
| X,D | US - A - 2 581 213 (SPOONER) | 1,2,3 | |
| | * Fig. 1,2 * | | |
| | -- | | |
| D,A | US - A - 3 248 646 (BRAZEE) | 1 | |
| | * Fig. 1,2 * | | |
| | -- | | |
| X,D | US - A - 3 800 216 (HAMILTON) | 1-3 | |
| | * Fig. 1; abstract * | | |
| | -- | | |
| X,D | US - A - 3 991 413 (BERGER) | 1-3 | |
| | * Abstract; fig. 1 * | | |
| | -- | | |
| X,D | GB - A - 1 481 850 (BRANDES) | 1-3 | |
| | * Fig. 1-3; claim 1 * | | |
| | -- | | |
| X,D | DE - A1 - 3 225 742 | 1-3,6, | |
| A | * Abstract; fig. 1,2 * | 4,5,7 | |

| | TECHNICAL FIELDS SEARCHED (Int. Cl. 4) |
|---|---|
| | G 01 R 31/00 |
| | G 01 D 5/00 |

The present search report has been drawn up for all claims

| Place of search | Date of completion of the search | Examiner |
|---|---|---|
| VIENNA | 04-07-1985 | KUNZE |